Europäisches Patentamt

European Patent Office

Office européen des brevets

(19)

(11) **EP 1 220 444 A1**

(12) **EUROPEAN PATENT APPLICATION**

(43) Date of publication:
**03.07.2002 Bulletin 2002/27**

(51) Int Cl.[7]: **H03F 3/347**, H03F 3/45

(21) Application number: **00403709.9**

(22) Date of filing: **28.12.2000**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **ALCATEL**
**75008 Paris (FR)**

(72) Inventors:
• **Jeanjean, François**
**1780 Wemel (BE)**
• **Verbist, Rudi**
**2223 Schriek (BE)**

(74) Representative: **Plas, Axel**
**Alcatel Bell N.V.,**
**Francis Wellesplein 1**
**2018 Antwerpen (BE)**

(54) **Differential output amplifier arrangement**

(57)     A differential output amplifier arrangement (DOA) comprises two operational amplifier (OA1, OA2) each having a feedback resistor (R2, R4). A pair of output resistors (R1, R3) couples the output terminals (OUT1, OUT2) of the operational amplifiers (OA1, OA2) to respective output terminals (ZOUTI, ZOUT2) of the arrangement (DOA), and a pair of input terminals (R7, R8) couples input terminals (IN1, IN2) of the arrangement (DOA) to negative polarity type input terminals (INN1, INN2) of the respective operational amplifiers (OA1, OA2). The positive polarity type input terminals (INP1, INP2) of the operational amplifiers (OA1, OA2) are grounded. Two additional resistors (R5, R6) cross-couple the output terminals (ZOUT1, ZOUT2) of the arrangement (DOA) to the negative polarity type input terminals (INN2, INN1) of the cross-coupled operational amplifiers (OA2, OA1).

Fig.

**Description**

The present invention relates to a differential output amplifier arrangement as defined in the non-characteristic part of claim 1.

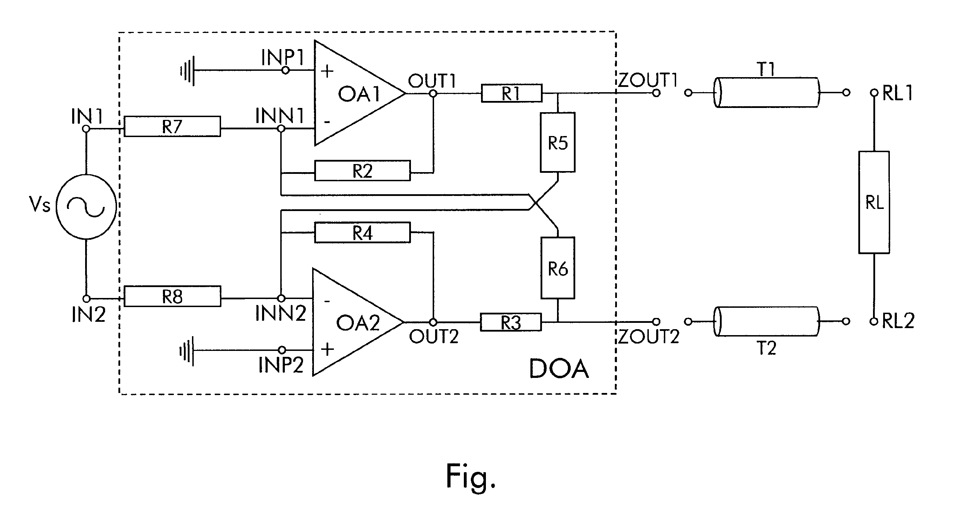

Such a differential output amplifier arrangement is already known in the art, e.g. from *the European Patent Application EP 0 901 221 from applicant Alcatel, entitled 'Differential Output Amplifier Arrangement and Method for Tuning the Output Impedance of a Differential Output Amplifier'.* The differential output amplifier arrangement disclosed therein is active back terminated. This means that a pair of resistors - R3 and R30 in the drawing of EP 0 901 221 - is foreseen between the outputs of the operational amplifiers and the output terminals of the arrangement, and that a pair of resistors - R4 and R40 in the drawing of EP 0 901 221 - is foreseen cross-coupling the output terminals of the arrangement to the negative input terminals of the cross-coupled operational amplifiers. Thanks to this active back termination, the power consumed by the differential output amplifier arrangement to generate a signal with a given level, reduces drastically, e.g. by a factor 2. The signal source is coupled to the positive input terminals of the operational amplifiers, whereas a resistor interconnects the negative input terminals of the operational amplifiers. This configuration at the entrance does not allow to realise the biasing and gain control for the amplifier arrangement with a minimum amount of components.

An object of the present invention is to provide a differential output amplifier arrangement similar to the known one, but whose biasing and gain control can be realised with a minimum amount of components.

According to the invention, this object is achieved by the differential output amplifier arrangement defined in claim 1.

Indeed, thanks to the presence of the seventh and eight resistors, which provide biasing and gain control, a signal source can be directly coupled to the input terminals of the amplifier arrangement according to the present invention. This signal source could not be directly coupled to the input terminals of the prior art amplifier arrangement because the biasing there required two resistors to be inserted between the signal source and the input terminals of the amplifier arrangement. These biasing resistors inherently form part of the amplifier arrangement according to the present invention wherein no longer a resistor interconnecting the negative input terminals of the two operational amplifiers is needed, which was the case in the prior art solution.

It is to be noticed that the term 'comprising', used in the claims, should not be interpreted as being limitative to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being limitative to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

An additional feature of the differential output amplifier arrangement according to the present invention is defined in claim 2.

Thus, a better load balance of the two operational amplifiers is obtained if the feedback resistors have substantially identical resistance values.

Additional advantageous features of the differential output amplifier arrangement according to the present invention are defined in claims 3 and 4.

In this way, by having the resistors of the active back termination pair-wise substantially equal, not only a better load balance of the operational amplifiers is obtained but also the design criteria and formulas that allow to select the values of the back termination resistors so that specific characteristics are obtained, become much simpler. This is explained in the already cited European Patent Application EP 0 901 221.

Another advantageous feature of the differential output amplifier arrangement according to the present invention is defined in claim 5.

Thus, the biasing resistors preferably have substantial equal resistance values.

Still an advantageous feature of the differential output amplifier arrangement according to the present invention is defined in claim 6.

In this way, the amplifier arrangement according to the present invention becomes a stable system from point of view of system theory, which implies that the arrangement will not oscillate.

The above mentioned and other objects and features of the invention will become more apparent and the invention itself will be best understood by referring to the following description of an embodiment taken in conjunction with the accompanying drawing that represents an embodiment of the differential output amplifier arrangement according to the present invention.

The differential output amplifier arrangement DOA represented in the drawing has two arrangement input terminals denoted by IN1 and IN2, and two arrangement output terminals denoted by ZOUT1 and ZOUT2. To the arrangement input terminals IN1 and IN2 terminals of a differential input signal source are coupled. The arrangement output terminals ZOUT1 and ZOUT2 are coupled to transmission lines T1 and T2.

The differential output amplifier arrangement DOA further includes two operational amplifiers, OA1 and OA2, having respective non-inverting input terminals INP1 and INP2, respective inverting input terminals INN1 and INN2, and having respective output terminals OUT1 and OUT2. The output terminal OUT1 of the first operational amplifier OA1 is coupled to the first arrangement output terminal ZOUT1 via a first resistor R1, and feedback coupled to the inverting input terminal INN1 of this first operational amplifier OA1 via a second resistor R2. Similarly, the output terminal OUT2 of the second operational amplifier OA2 is coupled to the second arrangement output terminal ZOUT2 via a third resistor R3, and feedback coupled to the inverting input terminal INN2 of this second operational amplifier OA2 via a fourth resistor R4.

The differential output amplifier arrangement DOA1 contains two additional resistors, a fifth resistor R5 cross-coupling the first arrangement output terminal ZOUT1 to the inverting input terminal INN2 of the second operational amplifier OA2, and a sixth resistor R6 cross-coupling the second arrangement output terminal ZOUT2 to the inverting input terminal INN1 of the first operational amplifier OA1. These two resistors, R5 and R6, together with the first resistor R1 and the third resistor R3 constitute an active back termination that allows to tune the output impedance of the arrangement DOA to a desired value. Typically it is desired that the output impedance of the arrangement DOA matches a load impedance which is denoted by RL in the drawing, and which in the drawing is coupled to the transmission lines T1 and T2 via terminals RL1 and RL2. The characteristic impedance of the transmission lines T1 and T2 is supposed to be equal to RL/2 for matching purposes. As is explained in the already cited European Patent Application EP 0 901 221, the voltage drop over the first resistor R1 and third resistor R3 of this active back termination allow the arrangement DOA to deliver an output signal having a given power with reduced supply voltage for the operational amplifiers OA1 and OA2, and/or with an increased dynamic range for both operational amplifiers OA1 and OA2.

The differential output amplifier arrangement DOA furthermore contains a seventh resistor R7 coupled between the first arrangement input terminal IN1 and the inverting input terminal INN1 of the first operational amplifier OA1, and an eighth resistor R8, coupled between the second arrangement input terminal IN2 and the inverting input terminal INN2 of the second operational amplifier OA2. Between the first input terminal IN1 and the second input terminal IN2 of the arrangement DOA, the differential input signal Vs is applied.

The formula for the output impedance of the differential output amplifier arrangement DOA, assuming that the resistors R1 and R3, R2 and R4, R5 and R6, R7 and R8 pair-wise have substantially identical resistance values, is given by:

$$\text{ZOUT} = \frac{2.R1.R5}{R1 + R5 - R2} \tag{1}$$

From this formula, it is understood that the sum of the resistance values R1 and R5 has to exceed the resistance value R2, a requirement that is also obtained from stability analysis for the arrangement DOA.

The gain of the differential output amplifier arrangement DOA, again assuming that the resistors R1 and R3, R2 and R4, R5 and R6, R7 and R8 pair-wise have substantially identical resistance values, is given by:

$$A = \frac{R7.R2 - R7.R1 + R7.R5 + 2.R2.R5}{2.R7.R1.R5 + RL.R7.R5 + RL.R7.R1 - RL.R7.R2} .RL \tag{2}$$

The resistance values R1, R2, R5 and R7 on the basis of the formula's (1) and (2) can be chosen so that the desired gain and arrangement output impedance are realised. Moreover, the resistors R7 and R8 that allow to tune the gain A of the differential output amplifier arrangement DOA, realise the input DC biasing. Such biasing is not realised by the arrangement known from EP 0 901 221, and has to be provided for there by two additional resistors coupling the input terminals of the operational amplifiers to the ground or a reference level. The biasing and gain control is thus more efficiently realised in the arrangement according to the present invention, since less components are required in the end.

Both formula's (1) and (2) assume that the operational amplifiers OA1 and OA2 are 'ideal' operational amplifiers, i.e. having an infinite input impedance, an infinite open loop gain, and a zero output impedance. Some precautions have to be taken when selecting the values for the resistors taking into account that in reality 'ideal' operational amplifiers do not exist.

An embodiment of the amplifier arrangement DOA can be used for instance in an ADSL (Asynchronous Digital Subscriber Line) line driver. The characteristic impedance in such a line driver is transformed by a hybrid into a value of 12.5 Ohm observed at the output of the operational amplifiers OA1 and OA2. The load resistance RL has an equivalent resistance value of 25 Ohm for matching purposes. The desired gain A is set by surrounding system considerations, that fall beyond the scope of this patent application. For such an embodiment, the operational amplifiers and resistance values may be chosen as follows:

- For the operational amplifiers, current amplifiers such as the AD816 may be chosen, because of their excellent current drive capability, and their low high frequency distortion, important characteristics for the ADSL application, as will be recognised by persons skilled in the art.
- The feedback resistors R2 and R4 are selected to obtain the desired gain-bandwidth product for the amplifier. These values are provided by the data sheets from the manufacturers of the operational amplifiers.
- R1 and R3 should on the one hand should be as small as possible to allow maximum power to the load. Since the operational amplifiers OA1 and OA2 are not ideal and in a closed-loop configuration by the presence of the feedback resistors R2 and R4, the non-zero output impedance of these amplifiers adds to the value of the resistors R1 and R3. To minimise this effect, the resistance values for R1 and R3 are selected to be at least one order of magnitude larger than the amplifier output impedance value.
- From the formula's (1) and (2), the values of R5 and R7 are then calculated.

While the principles of the invention have been described above in connection with specific apparatus, it is to be clearly understood that this description is made only by way of example and not as a limitation on the scope of the invention.

**Claims**

1. Differential output amplifier arrangement (DOA) comprising:

   - a first arrangement input terminal (IN1) and a second arrangement input terminal (IN2) for respectively coupling to a first terminal and a second terminal of an input signal source (Vs);
   - a first arrangement output terminal (ZOUT1) and a second arrangement output terminal (ZOUT2) for delivering a differential output voltage, said differential output;
   - a first operational amplifier (OA1) having a first amplifier input terminal (INP1) of a first polarity type (+), and a second amplifier input terminal (INN1) of a second polarity type (-) opposite of said first polarity type (+), and an amplifier output terminal (OUT1) coupled to said first arrangement output terminal (ZOUT1) via a first resistor (R1) and coupled to said second amplifier input terminal (INN1) of said first operational amplifier (OA1) via a second resistor (R2);
   - a second operational amplifier (OA2), having a first input terminal (INP2) of said first polarity type (+), and a second amplifier input terminal (INN2) of said second polarity type (-), and an amplifier output terminal (OUT2) coupled to said second arrangement output terminal (ZOUT2) via third resistor (R3) and coupled to said second amplifier input terminal (INN2) of said second operational amplifier (OA2) via a fourth resistor (R4);
   - a fifth resistor (R5) coupling said first arrangement output terminal (ZOUT1) to said second amplifier input terminal (INN2) of said second operational amplifier (OA2), and a sixth resistor (R6) coupling said second arrangement output terminal (ZOUT2) to said second amplifier input terminal (INN1) of said first operational amplifier (OA1),

   **CHARACTERISED IN THAT** said first amplifier input terminal (INP1 ) of said first operational amplifier (OA1) is coupled to a ground and said first amplifier input terminal (INP2) of said second operational amplifier is coupled to said ground, and **in that** said differential output amplifier arrangement (DOA) further comprises:

   - a seventh resistor (R7) coupling said first arrangement input terminal (IN1) to said second amplifier input terminal (INN1) of said first operational amplifier (OA1), and an eight resistor (R8) coupling said second arrangement input terminal (IN2) to said second amplifier input terminal (INN2) of said second operational amplifier (OA2).

2. Differential output amplifier arrangement (DOA) according to claim 1,
   **CHARACTERISED IN THAT** said second resistor (R2) and said fourth resistor (R4) have substantially identical resistance values.

3. Differential output amplifier arrangement (DOA) according to claim 1,
   **CHARACTERISED IN THAT** said first resistor (R1) and said third resistor (R3) have substantially identical resistance values.

4. Differential output amplifier arrangement (DOA) according to claim 1,
   **CHARACTERISED IN THAT** said fifth resistor (R5) and said sixth resistor (R6) have substantially identical resistance values.

5. Differential output amplifier arrangement (DOA) according to claim 1,
   **CHARACTERISED IN THAT** said seventh resistor (R7) and said eighth resistor (R8) have substantially identical resistance values.

6. Differential output amplifier arrangement (DOA) according to any one of the previous claims,
   **CHARACTERISED IN THAT** the resistance value of said second resistor (R2) is smaller than the sum of the resistance values of said first resistor (R1) and said fifth resistor (R5).

Fig.

EP 1 220 444 A1

**European Patent Office**

**EUROPEAN SEARCH REPORT**

Application Number

EP 00 40 3709

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | EP 0 901 221 A (CIT ALCATEL) 10 March 1999 (1999-03-10) * the whole document * | 1-6 | H03F3/347 H03F3/45 |
| Y | EP 0 809 353 A (TOKYO SHIBAURA ELECTRIC CO) 26 November 1997 (1997-11-26) * page 8, line 38 - page 9, line 55; figures 10,13 * | 1-6 | |
| A | FR 2 778 513 A (MATRA NORTEL COMMUNICATIONS) 12 November 1999 (1999-11-12) * claim 1; figure 1 * | 1 | |
| | | | TECHNICAL FIELDS SEARCHED (Int.Cl.7) |
| | | | H03F |

The present search report has been drawn up for all claims

| Place of search | Date of completion of the search | Examiner |
|---|---|---|
| THE HAGUE | 22 May 2001 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 220 444 A1**

## ANNEX TO THE EUROPEAN SEARCH REPORT
## ON EUROPEAN PATENT APPLICATION NO.

EP 00 40 3709

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2001

| Patent document cited in search report | | Publication date | Patent family member(s) | | Publication date |
|---|---|---|---|---|---|
| EP 0901221 | A | 10-03-1999 | US | 6097245 A | 01-08-2000 |
| EP 0809353 | A | 26-11-1997 | JP | 9312525 A | 02-12-1997 |
| | | | KR | 253727 B | 15-04-2000 |
| | | | US | 5841308 A | 24-11-1998 |
| FR 2778513 | A | 12-11-1999 | NONE | | |

EPO FORM P0459

For more details about this annex : see Official Journal of the European Patent Office, No. 12/82

8